# EUROPEAN PATENT APPLICATION

(11) **EP 4 502 291 A1**
(43) Date of publication of application: **05.02.2025**
(21) Application number: 23780711.0
(22) Date of filing: 29.03.2023
(51) Int. Cl.: E02F 9/16, H05K 5/02

(54) **WORKING MACHINE**

(30) Priority: 30.03.2022 JP 2022056716
(71) Applicant: KUBOTA CORPORATION, Osaka-shi, Osaka 556-8601 (JP)
(72) Inventor: TAKADA, Toshiki, Sakai-shi, Osaka 590-0908 (JP); SAKUTA, Takuya, Sakai-shi, Osaka 590-0908 (JP); KONISHI, Hironobu, Sakai-shi, Osaka 590-0908 (JP); MITSUI, Yusuke, Sakai-shi, Osaka 590-0908 (JP); NAKABAYASHI, Shintaro, Sakai-shi, Osaka 590-0908 (JP)
(74) Representative: Cabinet Beau de Loménie
(86) International application number: PCT/JP2023/012847
(87) International publication number: WO 2023/190702

(57) **Abstract**

To provide a working machine in which a communication unit (58) including a communication device (60) and an information processing device (59) is provided in a useful layout.

A working machine includes a machine body (2); a seat (6) on the machine body (2); and a communication unit (58) including an information processing device (59) and a communication device (60) to receive data from and transmit data to the information processing device (59), the communication device (60) containing a communication antenna (92) and configured to transmit data. The communication unit (58) is located at a position rearward of the seat (6) and lower than an upper end of the seat (6) such that the communication unit (58) overlaps the seat (6) in rear view.

## Description

### Technical Field

The present invention relates to a working machine.

### Background Art

A working machine disclosed in PTL 1 is known.

The working machine disclosed in PTL 1 includes a communication unit including an information processing device (first controller) that receives and transmits information relating to the working machine and performs processing and a communication device (working-machine wireless terminal) that receives data from and transmits data to the information processing device. The communication device transmits information relating to the working machine to an information collection terminal.

### Citation List

### Patent Literature

PTL 1: Japanese Unexamined Patent Application Publication No. 2013-16118

### Summary of Invention

### Technical Problem

In the working machine, when the communication unit including the communication device and the information processing device is mounted on the machine body, a useful layout is required.

In view of the above-described problem, an object of the present invention is to provide a working machine in which a communication unit including a communication device and an information processing device is provided in a useful layout.

### Solution to Problem

A working machine according to an aspect of the present invention includes a machine body; a seat on the machine body; and a communication unit including an information processing device and a communication device to receive data from and transmit data to the information processing device, the communication device containing a communication antenna and configured to transmit data. The communication unit is located at a position rearward of the seat and lower than an upper end of the seat such that the communication unit overlaps the seat in rear view.

The working machine may include a unit support to which the communication unit is attached; and a cover member to cover the communication unit and the unit support. The seat may include a seat portion for a user to sit on and a backrest portion provided at a rear portion of the seat portion such that the backrest portion is reclineable. The unit support may include a load receiver to receive a load from the backrest portion when the backrest portion is reclined and the backrest portion contacts the cover member.

The working machine may include an intervening member including an elastic member and provided between and in close contact with the cover member and the load receiver.

The working machine may include a seat protector on the machine body; a prime mover provided at a rear portion of the machine body; a hood to house the prime mover; and a support frame provided on the machine body to support the hood. The seat protector may include an attachment frame attached to the support frame. The unit support may include an attachment member attached to the attachment frame.

The unit support may include a pillar member vertically provided on the attachment member at a position that is rearward of the seat, a vertical member located at the same side of the pillar member as the seat and fixed to the pillar member such that the vertical member protrudes upward, and a first device bracket fixed at the opposite side of the vertical member from the seat. The communication device may be located above the pillar member and rearward of the first device bracket and may be attached to the first device bracket.

The load receiver may be provided at an upper end portion of the vertical member.

The unit support may include a second device bracket to which the information processing device is attached. The second device bracket may be provided on the attachment member such that the second device bracket is located sideward of the pillar member in a machine-body width direction.

### Advantageous Effects of Invention

With the above-described configuration, since the communication unit is located at a position rearward of the seat and lower than the upper end of the seat such that the communication unit overlaps the seat in rear view, the communication unit can be provided in a useful layout in which the communication unit does not hinder the user's front view, rear view, or side view.

### Brief Description of Drawings

[FIG. 1] FIG. 1 is a side view of a working machine.
[FIG. 2] FIG. 2 is a plan view of a machine body and the like.
[FIG. 3] FIG. 3 is a back view of the working machine.
[FIG. 4] FIG. 4 is a perspective view of a cabin.
[FIG. 5] FIG. 5 is a side view, partly in section, of a rear portion of the working machine.
[FIG. 6] FIG. 6 is a perspective view of a support frame and an attachment frame.
[FIG. 7] FIG. 7 is a back view illustrating an attachment structure of a communication unit.
[FIG. 8] FIG. 8 is a back view illustrating an attachment structure of a unit support.
[FIG. 9] FIG. 9 is a side sectional view of the communication unit, the unit support, and a cover member.
[FIG. 10] FIG. 10 is a side view illustrating a relationship between the cover member and a backrest portion when a seat is reclined.
[FIG. 11] FIG. 11 is a perspective view illustrating wiring of the communication unit.
[FIG. 12] FIG. 12 is a perspective view of the communication unit and the unit support.
[FIG. 13] FIG. 13 is an exploded perspective view of the communication unit and the unit support.
[FIG. 14] FIG. 14 is an exploded perspective view of the cover member.
[FIG. 15] FIG. 15 is a side sectional view of an upper portion of the unit support.
[FIG. 16] FIG. 16 is a perspective view illustrating an arrangement of the cover member.
[FIG. 17] FIG. 17 is a front sectional view of an attachment portion of an upper portion cover.

### Description of Embodiments

Hereinafter, an embodiment of the present invention will be described with reference to the drawings as appropriate.

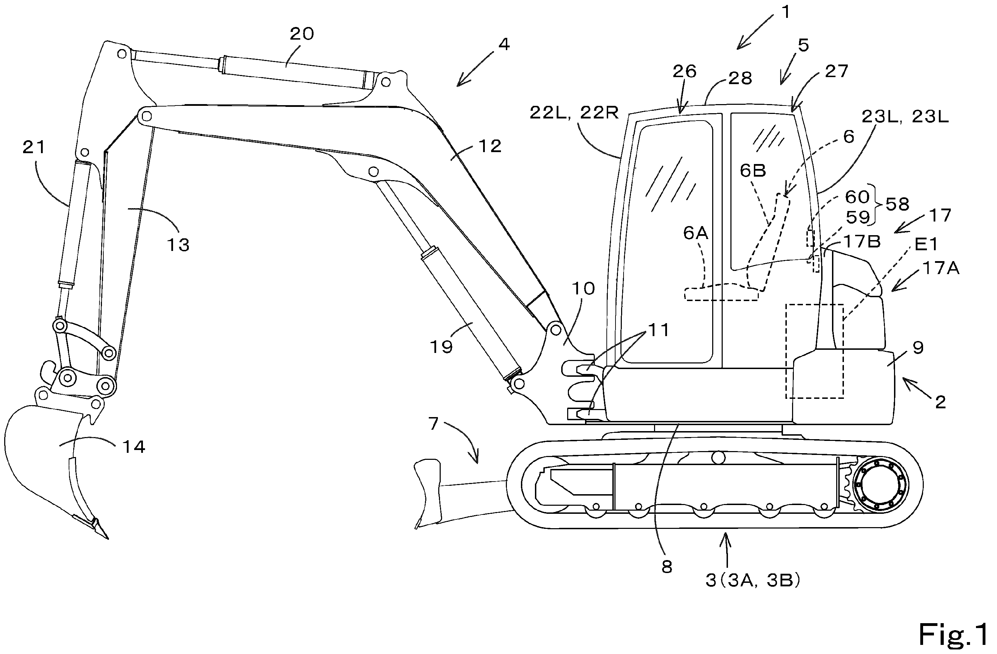

FIG. 1 is a side view illustrating an overall configuration of a working machine 1 according to the present embodiment. In the present embodiment, a backhoe, which is a turning working machine, is exemplified as the working machine 1.

As illustrated in FIG. 1, the working machine 1 includes a machine body (turning base) 2, a traveling device 3, and a front working device (working device) 4. A cabin 5 is mounted on the machine body 2. The cabin 5 is a seat protector that surrounds and protects a seat 6 mounted on the machine body 2.

In the present embodiment, the working machine (cabin-equipped working machine) 1 in which a communication unit 58 (DCU 60 and IPU 59) (described later) is mounted inside the cabin 5 mounted on the machine body 2 is exemplified, but a working machine (canopy-equipped working machine) 1 in which a canopy as a seat protector is mounted on a machine body 2 instead of the cabin 5 may be used, or a working machine 1 not including the cabin 5 or the canopy may be used.

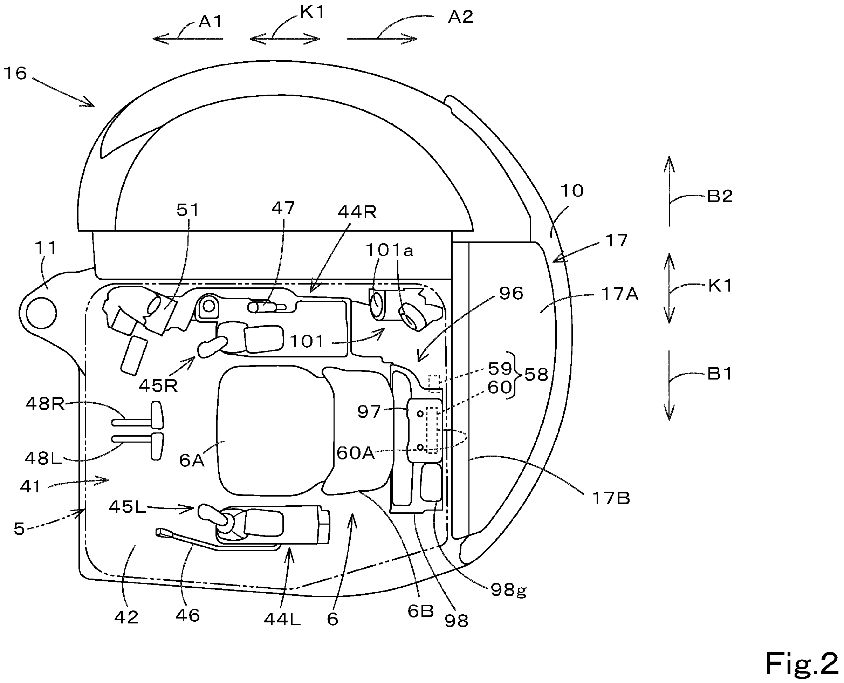

In the present embodiment, as illustrated in FIG. 1, a direction indicated by arrow A1 is referred to as a forward side, a direction indicated by arrow A2 is referred to as a rearward side, and a direction indicated by arrow K1 is referred to as a front-rear direction. Also, as illustrated in FIG. 2, a direction indicated by arrow B1 is referred to as a leftward side, a direction indicated by arrow B2 is referred to as a rightward side, and a direction indicated by arrow K2 is referred to as a machine-body width direction. The machine-body width direction K2 is a horizontal direction orthogonal to the front-rear direction K1.

Also, a direction from a central portion of the machine body 2 in the width direction toward the rightward side or the leftward side is referred to as an outward side in the machine-body width direction (outward in the machine-body width direction). A direction opposite to the outward side in the machine-body width direction is referred to as an inward side in the machine-body width direction (inward in the machine-body width direction).

As illustrated in FIG. 1, the traveling device 3 is a crawler type traveling device including a first crawler travel unit 3A provided at one of opposite sides (left) of the machine body 2 in the machine-body width direction K2 and a second crawler travel unit 3B provided at the other of the opposite sides (right) of the machine body 2 in the machine-body width direction K2. The machine body 2 is supported by the traveling device 3 so as to be able to travel. Also, the machine body 2 is supported on the traveling device 3 so as to be turnable about a vertical axis (an axis extending in an up-down direction). A dozer device 7 is attached to a front portion of the traveling device 3.

As illustrated in FIG. 1, the front working device 4 is located forward of the cabin 5. Also, the front working device 4 is attached to a front portion of the machine body 2. Specifically, the front working device 4 is supported by a swing bracket 10 so as to be swingable upward/downward. The swing bracket 10 is supported by a support bracket 11 so as to be rotatable about a vertical axis. The support bracket 11 is fixed to the machine body 2 and protrudes forward from the machine body 2.

Additionally, the front working device 4 includes a boom 12, an arm 13, and a working tool (bucket) 14. The boom 12 has a proximal portion pivotally supported by an upper portion of the swing bracket 10 so as to be rotatable and is swingable in the up-down direction. The arm 13 has a proximal portion pivotally supported by a distal end portion of the boom 12 so as to be rotatable and is swingable in a direction toward the boom 12 and in a direction away from the boom 12. The working tool 14 is pivotally supported by a distal end portion of the arm 13 so as to be rotatable and is swingable in a direction toward the arm 13 and in a direction away from the arm 13.

Additionally, the front working device 4 includes a boom cylinder 19 that drives the boom 12, an arm cylinder 20 that drives the arm 13, and a working tool cylinder 21 that drives the working tool 14. The boom cylinder 19, the arm cylinder 20, and the working tool cylinder 21 include hydraulic cylinders.

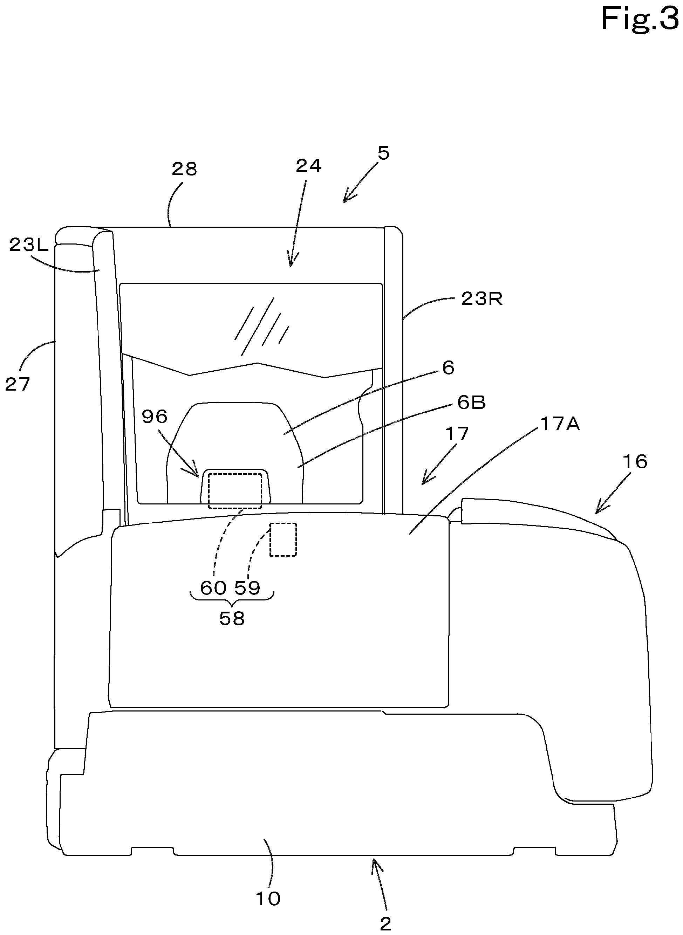

As illustrated in FIGS. 1, 3, and 4, the cabin 5 includes a pair of front pillars 22L and 22R provided in the machine-body width direction K2, a pair of rear pillars 23L and 23R provided in the machine-body width direction K2, a rear window 24 provided between the left rear pillar 23L and the right rear pillar 23R, a quarter pillar 25 provided between the left front pillar 22L and the left rear pillar 23L, a door 26 provided between the left front pillar 22L and the quarter pillar 25, a side window 27 provided between the quarter pillar 25 and the left rear pillar 23R, a roof 28 defining a top portion, and the like. A front window is provided between the left front pillar 22L and the right front pillar 22R. The front window, the rear window 24, and the side window 27 have window openings and glasses that close the window openings. Each of the glasses has light transmissivity.

As illustrated in FIG. 2, a rear portion of the machine body 2 is in a curved shape (arc shape) that is convex rearward in a plan view. Specifically, the rear portion of the machine body 2 is in a convex curved shape in which a central portion in the machine-body width direction K2 protrudes most rearward.

As illustrated in FIG. 2, the machine body 2 is provided with an operation section 41 including the seat 6 on which a user (driver) sits. The operation section 41 is located closer to one of opposite sides (left side) of the machine body 2 in the machine-body width direction K2 than to the other of the opposite sides. A cover body 16 that houses devices (for example, a hydraulic fluid tank, a control valve, a battery, and the like) provided on the machine body 2 is located closer to the other of the opposite sides (right side) of the machine body 2 in the machine-body width direction K2 than to the one of the opposite sides. The operation section 41 includes a floor portion 42 attached to the machine body 2.

As illustrated in FIG. 2, the seat 6 is provided at a position deviated in a first direction (leftward) along the machine-body width direction K2 from the central portion of the machine body 2 in the machine-body width direction K2. As illustrated in FIGS. 1 and 2, the seat 6 includes a seat portion 6A for the user to sit on (supporting the buttocks of the user) and a backrest portion 6B that supports the back of the user. The backrest portion 6B is provided at a rear portion of the seat portion 6A such that the backrest portion 6B is reclineable. A forward side is the front of the user seated on the seat 6.

As illustrated in FIG. 2, the operation section 41 includes a console (operator base) 44L located at one of opposite sides (one side) of the seat 6 in the machine-body width direction K2, and a console (operator base) 44R located at the other of the opposite sides (other side) of the seat 6 in the machine-body width direction K2. Specifically, the console 44L is located leftward of the seat 6, and the console 44R is located rightward of the seat 6.

The console 44L is provided with an unloading lever 46 and a manual operator 45L. The unloading lever 46 is swingable in the up-down direction together with the console 44L. In a state in which the unloading lever 46 and the console 44L have swung upward, a hydraulic fluid cannot be supplied to a hydraulic device. In a state in which the unloading lever 46 and the console 44L have swung downward, the hydraulic fluid can be supplied to the hydraulic device.

The console 44R is provided with various switches, a manual operator 45R, and a dozer lever 47 that operates the dozer device 7. A meter 51 is provided at a front portion of the console 44R. The meter 51 includes a display (including a liquid crystal screen or the like). The display can display, for example, basic information on the working machine 1, images of the surroundings of the working machine 1, information required for making various settings of the working machine 1, and the like.

The left manual operator 45L and the right manual operator 45R each can operate two operation targets. For example, the manual operator 45L can perform a turn operation of the machine body 2 and a swing operation of the arm 13. The manual operator 45R can perform a swing operation of the boom 12 and a swing operation of the working tool 14.

As illustrated in FIG. 2, the operation section 41 includes two traveling levers 48L and 48R located forward of the seat 6. The two traveling levers 48L and 48R are arranged in the machine-body width direction K2. The left traveling lever 48L can operate the first crawler travel unit 3A, and the right traveling lever 48R can operate the second crawler travel unit 3B.

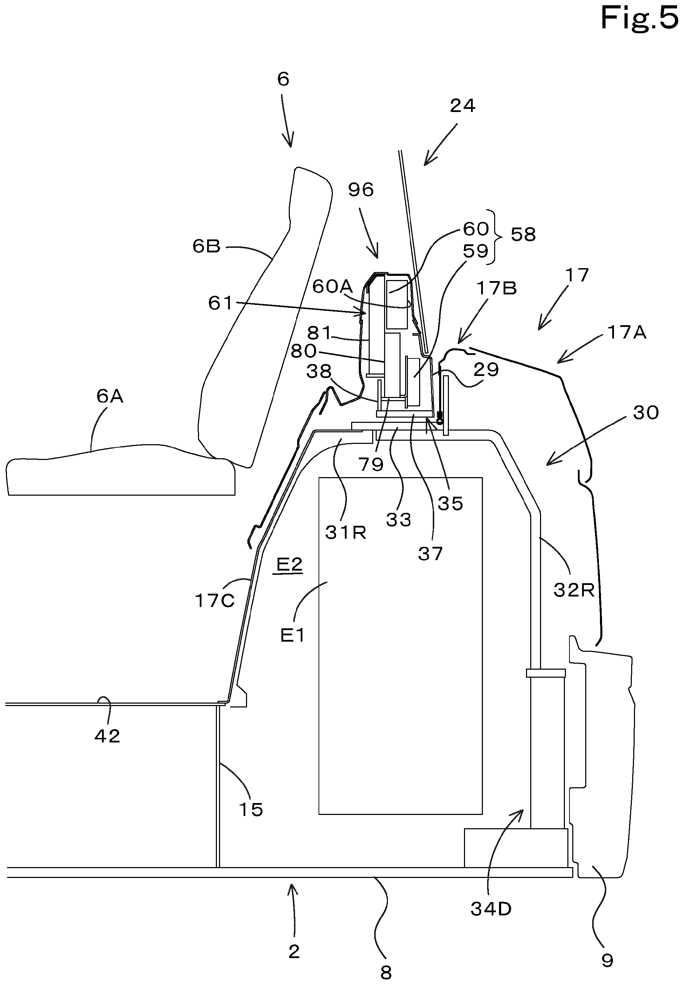

As illustrated in FIGS. 1, and 5, a prime mover (engine) E1 is provided at the rear portion of the machine body 2. Additionally, a hood 17 defining a prime mover chamber E2 that houses the prime mover E1 is provided on the rear portion of the machine body 2.

As illustrated in FIGS. 2, 3, and 5, the hood 17 includes a rear portion cover 17A, a gap hiding member 17B, a partition wall member 17C, and the like. The rear portion cover 17A covers the rear of the prime mover E1. The gap hiding member 17B closes a gap between the rear portion cover 17A and the cabin 5. As illustrated in FIG. 5, the partition wall member 17C covers the front of the prime mover E1 and separates the prime mover chamber E2 from the operation section 41 (seat 6).

As illustrated in FIG. 5, the prime mover chamber E2 is defined by the hood 17, a turning base plate (base plate) 8, a partition plate 15, a weight 9, and the like. The turning base plate 8 is made of a thick plate material and defines a bottom portion of the machine body 2. The partition plate 15 is positioned such that plate surfaces face in the front-rear direction K1 and is vertically provided on the turning base plate 8. The weight 9 defines the rear portion of the machine body 2 and is attached to a rear portion of the turning base plate 8.

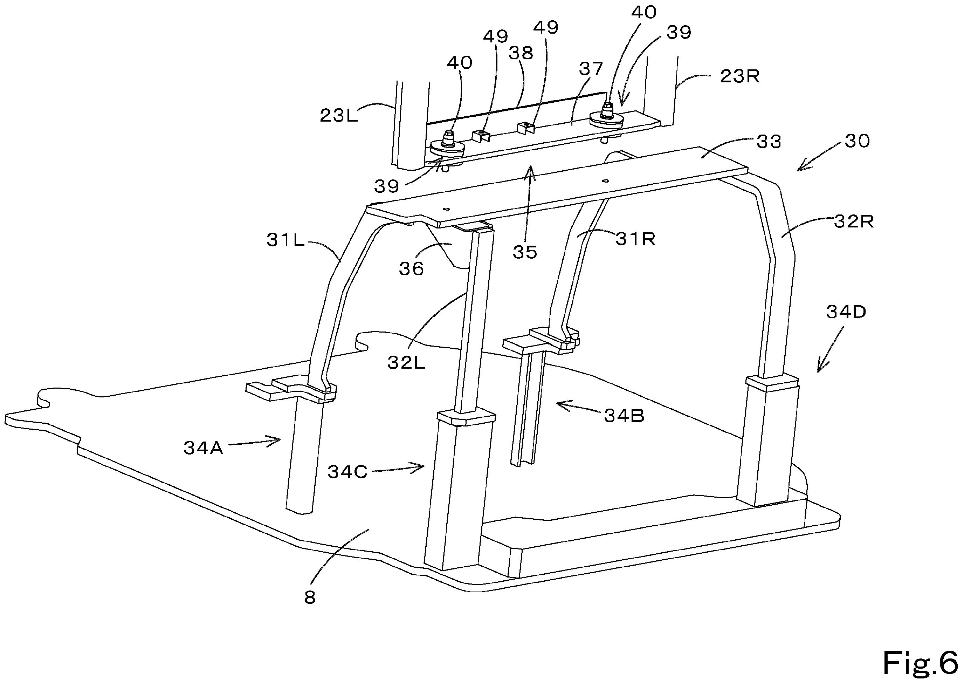

As illustrated in FIGS. 5 and 6, a support frame 30 that supports the hood 17 and devices and components in the prime mover chamber E2 is provided inside the prime mover chamber E2. The support frame 30 is mounted on the machine body 2. Specifically, the support frame 30 includes a left front leg 31L, a right front leg 31R, a left rear leg 32L, a right rear leg 32R, and a top plate 33. The left front leg 31L is attached to a fixing member 34A fixed to the turning base plate 8. The right front leg 31R is attached to a fixing member 34B fixed to the turning base plate 8. The left rear leg 32L is attached to a fixing member 34C fixed to the turning base plate 8. The right rear leg 32R is attached to a fixing member 34D fixed to the turning base plate 8. A bracket member 36 is fixed to an upper portion of the left rear leg 32L. The top plate 33 is positioned such that plate surfaces face in the up-down direction and is provided across an upper portion of the right front leg 31R and the bracket member 36, and across upper portions of the left front leg 31L and the left rear leg 32L. Also, the top plate 33 is fixed to the left front leg 31L, the bracket member 36, the left rear leg 32L, and the right rear leg 32R by welding or the like.

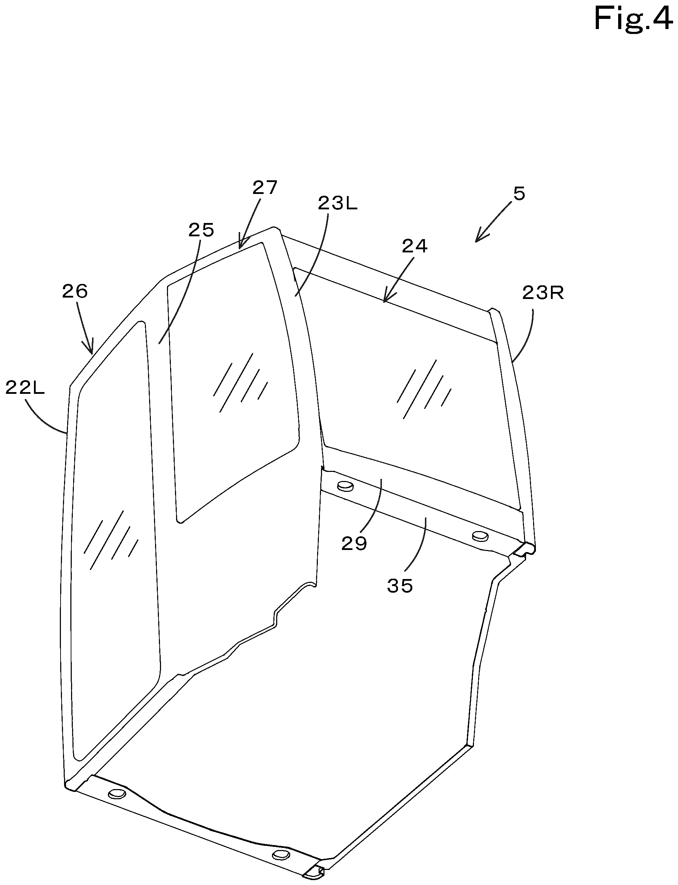

As illustrated in FIG. 4, the cabin 5 includes an attachment frame 35 that couples lower portions of the left rear pillar 23L and the right rear pillar 23R to each other. The attachment frame 35 is provided on an interior side of the cabin of a coupling portion 29 that couples the lower portions of the left rear pillar 23L and the right rear pillar 23R of the exterior of the cabin 5 to each other. The attachment frame 35 is attached to the support frame 30. Thus, a rear portion of the cabin 5 is supported.

As illustrated in FIGS. 5 and 6, the attachment frame 35 includes a base member 37 and a vertical plate 38. The base member 37 is made of a plate material, and is provided across the left rear pillar 23L and the right rear pillar 23R such that plate surfaces face in the up-down direction. The lower portion of the rear pillar 23L is fixed to a left end of the base member 37 by welding or the like. The lower portion of the rear pillar 23R is fixed to a right end of the base member 37 by welding or the like.

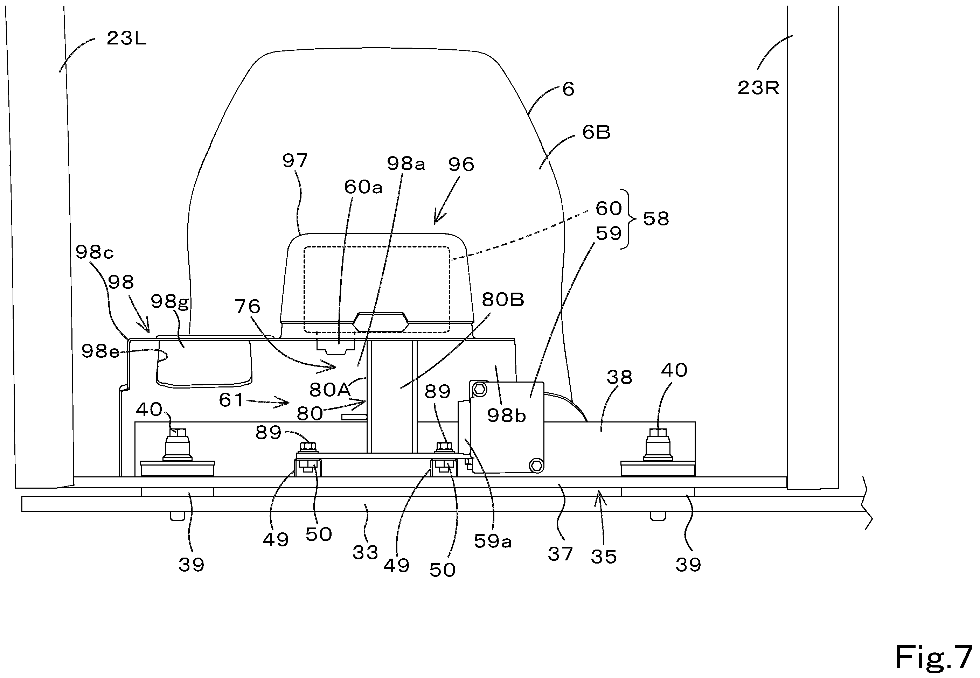

As illustrated in FIG. 7, the base member 37 is attached to the top plate 33 of the support frame 30 via vibration isolation members 39. Thus, the base member 37 is supported by the top plate 33 via the vibration isolation members 39 in a vibration-isolating manner. Specifically, the base member 37 is located above the top plate 33. The vibration isolation members 39 are assembled to the base member 37. The base member 37 is fixed to the top plate 33 by bolt members 40 that penetrate the vibration isolation members 39 and are screwed into the top plate 33 from above.

As illustrated in FIG. 7, the vibration isolation members 39 are provided on a left portion and a right portion of the base member 37. A pair of fixing brackets 49 are provided on the base member 37 in the machine-body width direction K2. The pair of fixing brackets 49 are provided between the left vibration isolation member 39 and the right vibration isolation member 39.

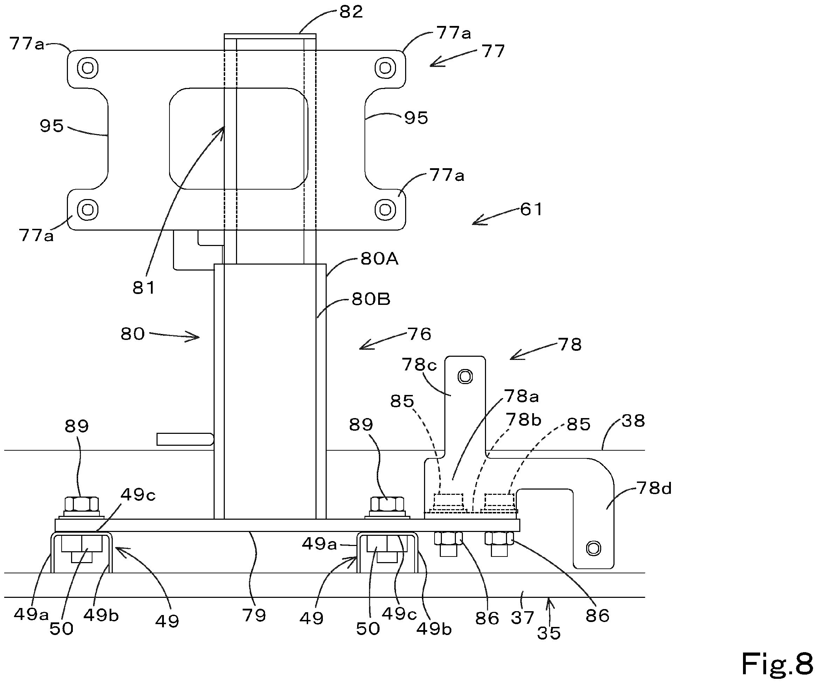

As illustrated in FIG. 8, each of the fixing brackets 49 is obtained by bending a plate material, and includes a first wall portion 49a and a second wall portion 49b that are arranged to face each other in the machine-body width direction K2 and fixed to an upper surface of the base member 37 by welding or the like, and a third wall portion 49c that is a wall portion having plate surfaces facing in the up-down direction and couples upper ends of the first wall portion 49a and the second wall portion 49b to each other. A nut member 50 is fixed to a lower surface of the third wall portion 49c.

As illustrated in FIG. 6, the vertical plate 38 is made of a plate material long in the machine-body width direction K2, is located at a front portion of the base member 37 such that plate surfaces face in the front-rear direction K1, and is vertically provided on the base member 37. A lower end of the vertical plate 38 is fixed to the upper surface of the base member 37 by welding or the like.

As illustrated in FIGS. 1 and 2, a communication unit 58 is mounted on the working machine 1. The communication unit 58 is located rearward of the seat 6. Specifically, the communication unit 58 is located at a position that is rearward of the seat 6 and lower than an upper end of the seat 6 (backrest portion 6B), and overlaps the seat 6 in rear view (as viewed from the rear).

The communication unit 58 includes an information processing unit (IPU, information collection unit) 59 and a direct communication unit (DCU) 60.

As illustrated in FIG. 5, the DCU 60 is located rearward of an upper portion of the backrest portion 6B. Also, the DCU 60 is positioned such that a device front surface 60A of the DCU 60 faces rearward (a glass surface of the rear window 24). Also, as illustrated in FIG. 7, the DCU 60 is located at a substantially central portion of the seat 6 (backrest portion 6B) in the machine-body width direction K2 in the rear view. That is, the DCU 60 is located rearward of the substantially central portion of the seat 6 (backrest portion 6B) in the machine-body width direction K2.

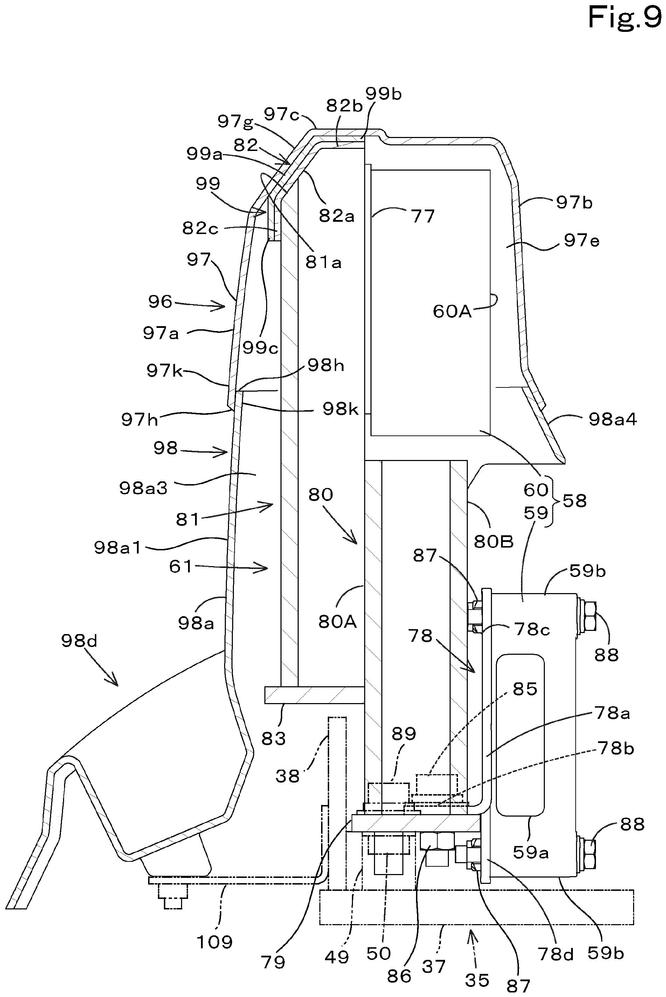

As illustrated in FIGS. 5 and 9, the IPU 59 is located lower than and rearward of the DCU 60. Also, the IPU 59 is displaced from the DCU 60 in the machine-body width direction K2. In the present embodiment, the IPU 59 is displaced rightward from the DCU 60. By providing the communication unit 58 at a position that is rearward of the seat 6 and lower than the upper end of the seat 6 such that the communication unit 58 overlaps the seat 6 in rear view, the communication unit 58 can be provided in a useful layout in which the communication unit 58 does not hinder the user's front view, rear view, or side view.

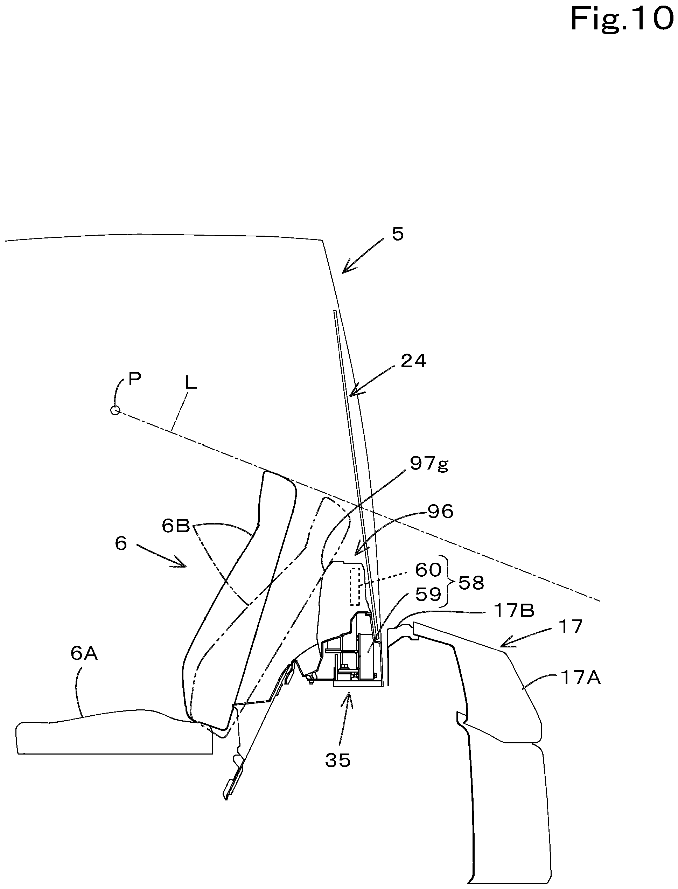

As illustrated in FIG. 10, assuming that the position of the eyes (eye point) of the user sitting on the seat 6 is P, the communication unit 58 (IPU 59 and DCU 60) is located in a region lower than a line of sight L of the user. The line of sight L extends from the eye point P and is in contact with the upper end of the backrest portion 6B. That is, the rear view of the user sitting on the seat 6 is prevented from being blocked by the communication unit 58 and a cover member 96 (described later), and the rear view of the user can be ensured.

The IPU 59 is an "information processing device" that temporarily stores information relating to the working machine 1 and performs predetermined processing (for example, compression processing and/or the like).

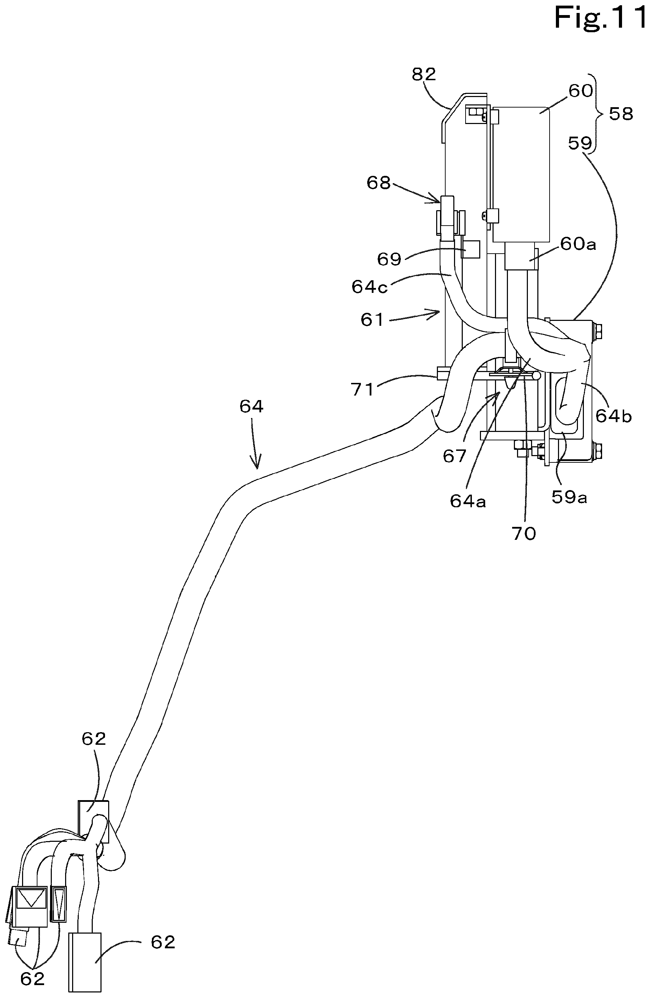

As illustrated in FIG. 11, the IPU 59 is connected to a communication port of an on-board communication network, a communication port of on-board diagnostics (OBD), a connection port of a harness of the cabin 5, and the like via a harness 64 and connector(s) 62. One of the connectors 62 is connected to the communication port of the on-board communication network, another one of the connectors 62 is connected to the communication port of the on-board diagnostics, and still another one of the connectors 62 is connected to the connection port of the harness of the cabin 5.

The on-board communication network includes a controller area network (CAN), a FlexRay, and/or the like provided in the working machine 1. The harness 64 includes a plurality of (a large number of) bundled electric wires (wiring). The IPU 59 receives and transmits information on the working machine 1 from and to the communication network and the on-board diagnostics.

Also, the harness 64 is branched into a branch portion 64a connected to the DCU 60, a branch portion 64b connected to the IPU 59, and a branch portion 64c connected to a fuse 68 for the DCU 60, in the vicinity of the communication unit 58 (IPU 59). The IPU 59 is connected to the DCU 60 via the harness 64, and transmits data to the DCU 60. Also, the IPU 59 and the DCU 60 are connected to a power supply port (not illustrated) via the harness 64 and one of the connectors 62. Power is supplied from the power supply port.

The DCU 60 is a "communication device" that performs communication using data with an external device (not illustrated). The DCU 60 receives data from and transmits data to the IPU 59. Also, the DCU 60 transmits data received from the IPU 59 and data such as position information to a server. Examples of the server include a server installed in a manufacturer (manufacturing company) that manufactures the working machine 1, a server installed in a dealer (sales and maintenance company) that sells and maintains the working machine 1, and the like.

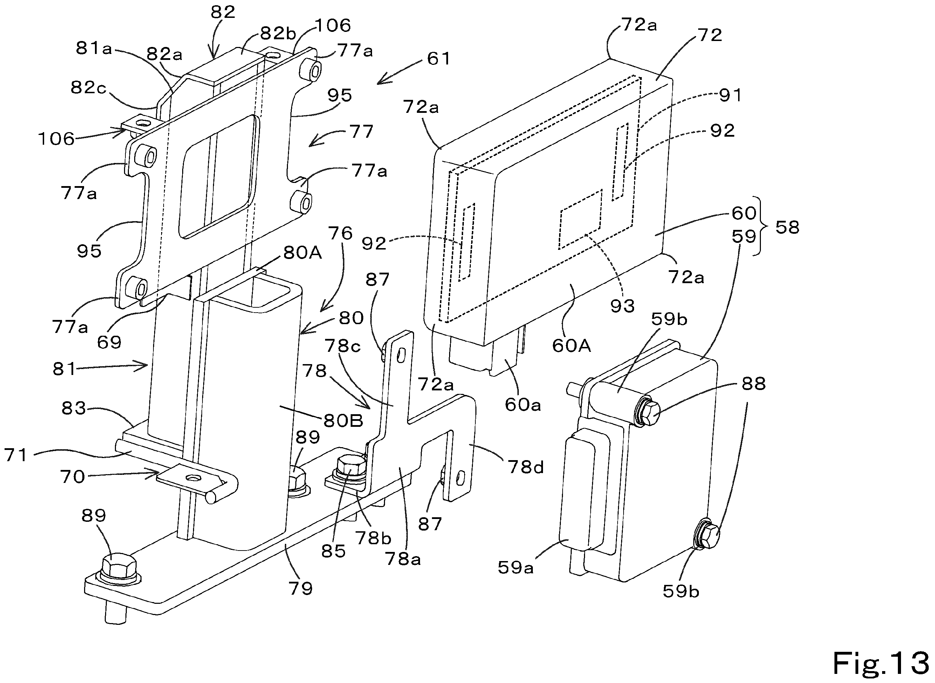

As illustrated in FIG. 13, the IPU 59 has a substantially rectangular parallelepiped shape in which surfaces facing in the front-rear direction K1 are substantially rectangular, and is positioned vertically such that the longitudinal direction of the rectangular parallelepiped coincides with the up-down direction. Also, the IPU 59 has a substantially rectangular parallelepiped shape in which the width in the front-rear direction K1 (the width in the thickness direction) is narrower than the width in the up-down direction and the width in the machine-body width direction K2. The IPU 59 includes a connection portion 59a on a left surface. The branch portion 64b (harness 64) is connected to the connection portion 59a.

As illustrated in FIG. 13, the DCU 60 has a substantially rectangular parallelepiped shape in which the device front surface 60A is substantially rectangular and is positioned horizontally such that the longitudinal direction of the rectangular parallelepiped coincides with the machine-body width direction K2. Also, the DCU 60 has a substantially rectangular parallelepiped shape in which the width in the front-rear direction K1 (the width in the thickness direction) is narrower than the width in the up-down direction and the width in the machine-body width direction K2. The DCU 60 is positioned such that the device front surface 60A faces rearward (faces away from the seat 6). The DCU 60 includes a connecting portion 59a on a left portion of a lower surface. The branch portion 64a (harness 64) is connected to the connection portion 59a.

As illustrated in FIG. 13, the DCU 60 includes a case 72 and an electronic substrate 91 housed in the case 72. The case 72 is in a rectangular parallelepiped shape. Communication antenna(s) (for example, a 3G antenna or the like) 92 and a positioning antenna (GPS antenna) 93 are attached to the electronic substrate 91, on a front side on which electronic components are attached. The electronic substrate 91 is housed in the case 72 such that the front side faces the device front surface 60A of the DCU 60. The at least one communication antenna 92 is an antenna for communication with a server, and includes communication antennas 92 provided at a left portion and a right portion of the electronic substrate 91. The communication antennas 92 are contained in the DCU 60. In the DCU 60 of the present embodiment, since the communication antennas 92 are contained in the DCU 60, when an illegal act such as theft (an act of removing the DCU 60, or the like) is being performed, a communicable state can be maintained and a report can be made to a predetermined report destination.

The positioning antenna 93 receives satellite signal(s) transmitted from positioning satellite(s). The positioning antenna 93 is provided at a lower and right portion of the electronic substrate 91. The working machine 1 detects its own position (measured position information including latitude and longitude) by a positioning system based on the satellite signals received by the positioning antenna 93. Specifically, the working machine 1 determines the position and the orientation of the working machine 1 by using a known global positioning system (GPS) that is an example of a global navigation satellite system (GNSS) (for example, by an RTK-GPS suitable for position measurement of a moving body). That is, the working machine 1 communicates with a base station (reference station) installed at a known position, and the base station transmits measured position data (correction information) obtained by receiving radio waves from the positioning satellites to the working machine 1. The working machine 1 detects its own position (latitude and longitude) based on measured position data obtained by receiving the radio waves from the positioning satellites and the measured position data from the base station. The DCU 60 transmits and receives position information.

As illustrated in FIGS. 7 to 9, 12, and 13, the working machine 1 includes a unit support 61 that supports the communication unit 58. Specifically, the unit support 61 is attached to the attachment frame 35. The communication unit 58 (DCU 60 and IPU 59) is attached to the unit support 61. The unit support 61 includes a base bracket 76, a first device bracket 77, and a second device bracket 78. The base bracket 76 is attached to the attachment frame 35. The DCU 60 is attached to the first device bracket 77 with the device front surface 60A facing rearward. The IPU 59 is attached to the second device bracket 78.

Next, the unit support 61 will be described in detail.

As illustrated in FIGS. 7 and 8, the base bracket 76 includes an attachment member 79, a pillar member 80, a vertical member 81, and a load receiver 82.

As illustrated in FIG. 8, the attachment member 79 is attached to the attachment frame 35. Specifically, the attachment member 79 is made of a plate material long in the machine-body width direction K2, and is located above the base member 37 of the attachment frame 35 such that plate surfaces face in the up-down direction. The attachment member 79 is placed on the left and right fixing brackets 49 such that a right portion of the attachment member 79 protrudes rightward from the right fixing bracket 49. The attachment member 79 is fixed to the fixing bracket 49 by bolt members 89 that penetrate the attachment member 79 and the third wall portions 49c of the fixing brackets 49 and are screwed into the nut members 50 from above. That is, the attachment member 79 is attached to the attachment frame 35 via the fixing brackets 49.

As illustrated in FIG. 5, the pillar member 80 is vertically provided on the attachment member 79 at a position that is rearward of the seat 6. Specifically, as illustrated in FIGS. 8 and 13, the pillar member 80 includes a first member 80A and a second member 80B. The first member 80A is made of a plate material long in the up-down direction, and is located above a front portion of a middle portion in the machine-body width direction K2 of the attachment member 79 such that plate surfaces face in the front-rear direction K1. The second member 80B is made of a channel steel, and is located rearward of the first member 80A such that an opening faces forward and the longitudinal direction coincides with the up-down direction. The second member 80B is fixed to a rear surface of the first member 80A by welding or the like. Lower ends of the first member 80A and the second member 80B are fixed to an upper surface of the attachment member 79 between the pair of bolt members 89 by welding or the like.

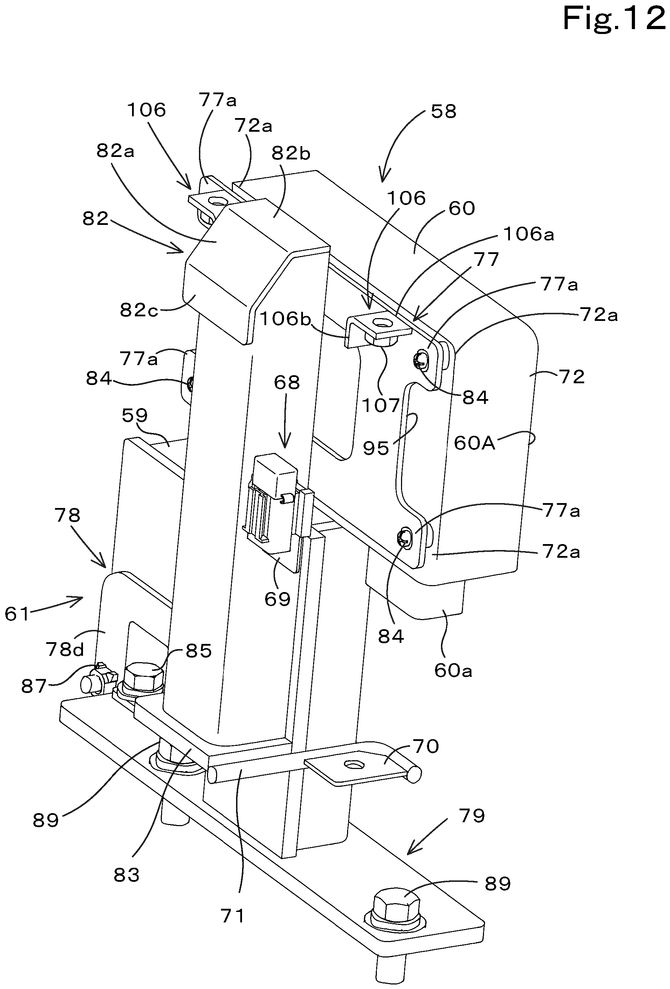

As illustrated in FIG. 9, a support plate 83 is fixed to a front and lower portion of the pillar member 80. As illustrated in FIG. 12, the support plate 83 is made of a quadrangular plate material, and is fixed to a lower portion of a front surface of the first member 80A by welding or the like such that plate surfaces face in the up-down direction. As illustrated in FIG. 12, a stay attachment member 71 is fixed to a left end portion of the support plate 83. A clamp stay 70 to which a holding tool 67 (see FIG. 11) that holds the harness 64 is attached is fixed to the stay attachment member 71.

As illustrated in FIGS. 9 and 12, the vertical member 81 is located forward of the pillar member 80, that is, at the same side of the pillar member 80 as the seat 6. Also, the vertical member 81 is located above the support plate 83. The vertical member 81 is made of a channel steel, and is positioned such that an opening faces rearward and the longitudinal direction coincides with the up-down direction. A lower end of the vertical member 81 is fixed to an upper surface of the support plate 83 by welding or the like. Also, a lower portion of a rear surface of the vertical member 81 is fixed to a front surface of the pillar member 80 (first member 80A) by welding or the like. The vertical member 81 protrudes upward from the pillar member 80. That is, the vertical member 81 is fixed to the pillar member 80 in an upwardly protruding manner. As illustrated in FIG. 12, a fuse stay 69 for attaching the fuse 68 is fixed to a middle portion in the up-down direction of the vertical member 81.

As illustrated in FIGS. 9, 12, and 15, the load receiver 82 is provided at an upper end portion of the vertical member 81. Specifically, the load receiver 82 is obtained by bending a plate material, and includes a main section 82a, an upper portion wall 82b, and a lower portion wall 82c. The main section 82a is inclined such that the main section 82a extends diagonally downward and forward. The upper portion wall 82b extends rearward from an upper end of the main section 82a. The lower portion wall 82c extends downward from a lower end of the main section 82a. An upper and front portion of the vertical member 81 is in an inclined shape to conform to the shape of the main section 82a. That is, the vertical member 81 includes an inclined section 81a at the upper and front portion. The main section 82a closely abuts on the inclined section 81a. The upper portion wall 82b abuts on the upper end of the vertical member 81. The lower portion wall 82c abuts on a front surface of the vertical member 81. The load receiver 82 is fixed to the upper end portion of the vertical member 81 by welding or the like.

As illustrated in FIGS. 12 and 13, the first device bracket 77 is made of a metal plate material (sheet metal member), and is located rearward of the vertical member 81 such that plate surfaces face in the front-rear direction K1. Specifically, the first device bracket 77 is located above the pillar member 80. A middle portion (substantially central portion) in the machine-body width direction K2 is fixed to the rear surface of the vertical member 81 by welding or the like.

As illustrated in FIG. 12, the DCU 60 is located above the pillar member 80 and rearward of the first device bracket 77. The opposite surface (device back surface) of the DCU 60 from the device front surface 60A is attached to the first device bracket 77. In other words, the DCU 60 is attached to the first device bracket 77 with the device front surface 60A facing away from the seat 6. The DCU 60 and the first device bracket 77 are located at positions located rearward of the load receiver 82 and lower than an upper end of the load receiver 82. That is, the DCU 60 and the first device bracket 77 are located at positions at which the backrest portion 6B does not contact the DCU 60 or the first device bracket 77 when the seat 6 is reclined.

As illustrated in FIG. 13, the first device bracket 77 includes a plurality of cover attachment portions 77a. Attached portions 72a at four corners of the case 72 are attached to the cover attachment portions 77a by screws 84 or the like.

As illustrated in FIG. 13, the first device bracket 77 has cutouts 95 corresponding to the communication antennas 92. The communication antennas 92 have directivity in the plate thickness direction of the electronic substrate 91. The portions of the first device bracket 77 corresponding to the communication antennas 92 are cut out so as not to disturb radio wave directivity of the communication antennas 92.

As illustrated in FIGS. 8, 9, and 13, the second device bracket 78 is made of a plate material and is located on a right portion of the attachment member 79. In other words, the second device bracket 78 is provided on the attachment member 79, on a side (rightward) of the pillar member 80 in the machine-body width direction K2. The second device bracket 78 includes a first wall portion 78a, a second wall portion 78b, a third wall portion 78c, and a fourth wall portion 78d. The first wall portion 78a is positioned such that plate surfaces face in the front-rear direction K2. The second wall portion 78b extends forward from a lower end of the first wall portion 78a. The third wall portion 78c extends upward from an upper end of the first wall portion 78a. The fourth wall portion 78d extends rightward from a right end of the first wall portion 78a and then extends downward.

The second wall portion 78b is overlapped with the upper surface of the attachment member 79 and is attached to the attachment member 79 by bolt members 85 and nut members 86.

Nut members 87 are fixed to front surfaces of the projecting portions of the third wall portion 78c and the fourth wall portion 78d.

As illustrated in FIGS. 9 and 13, attachment bosses 59b are provided at an upper and left portion and a lower and right portion of the IPU 59. The IPU 59 is provided on a rear surface of the second device bracket 78 and is fixed to the second device bracket 78 by bolt members 88 that penetrate the attachment bosses 59b and the second device bracket 78 and are screwed into the nut members 87.

As illustrated in FIGS. 5, 7, and 9, the working machine 1 includes a cover member 96 that covers the communication unit 58 and the unit support 61. The cover member 96 is made of resin so as not to disturb communication performance of the DCU 60.

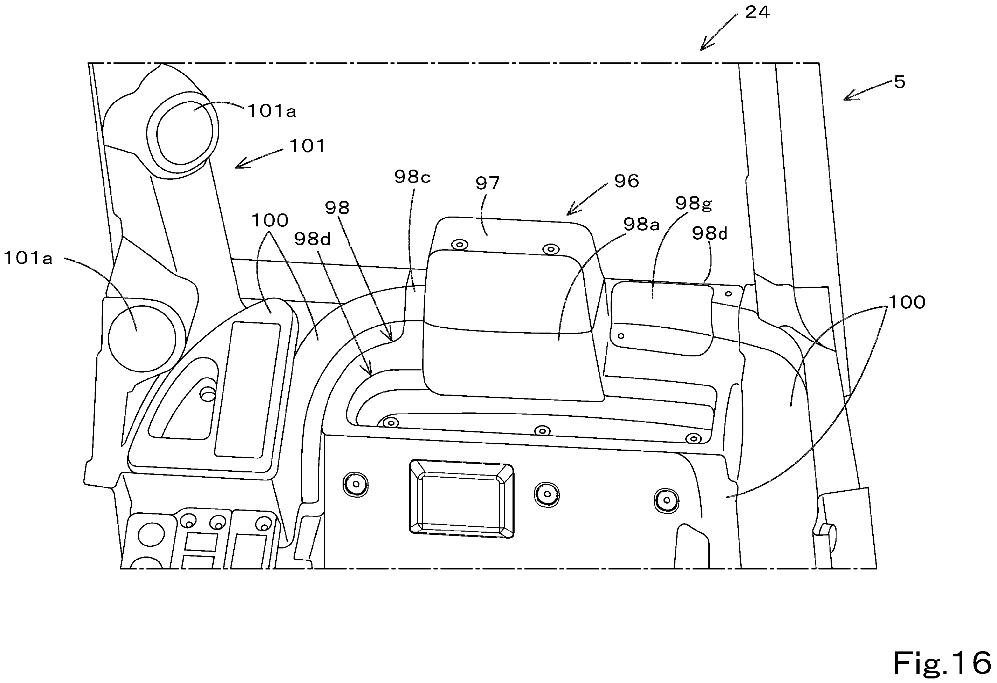

As illustrated in FIG. 16, the cover member 96 is provided in a rear portion of the interior of the cabin 5, and covers the communication unit 58 and the unit support 61 from the interior side of the cabin 5 so that the communication unit 58 and the unit support 61 are not exposed to the interior side of the cabin 5. Also, the cover member 96 and an interior material 100 around the cover member 96 are a portion of interiors of the cabin 5. Additionally, a duct 101 for air conditioning having blowout port(s) 101a for blowing out conditioned air is provided rightward of the cover member 96.

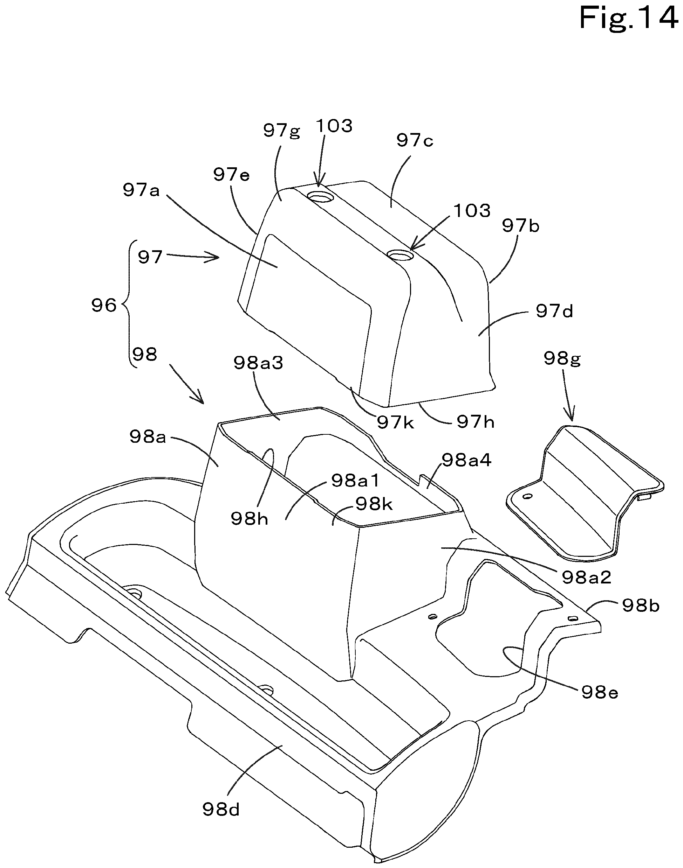

As illustrated in FIG. 14, the cover member 96 includes an upper portion cover 97 and a lower portion cover 98.

As illustrated in FIG. 9, the upper portion cover 97 covers an upper portion of the unit support 61 and the DCU 60. Specifically, the upper portion cover 97 includes a front wall 97a that covers the upper portion of the vertical member 81 and the front of the load receiver 82; a rear wall 97b that covers the rear of the DCU 60; an upper wall 97c that covers the upper side of the vertical member 81, the load receiver 82, and the DCU 60; a first side wall 97d (see FIG. 14) that covers the left of the vertical member 81, the load receiver 82, and the DCU 60; and a second side wall 97e that covers the right of the load receiver 82 and the DCU 60. By removing the upper portion cover 97, for example, the fuse 68 can be replaced.

The upper portion cover 97 is in a shape opening downward. That is, the upper portion cover 97 has an opening 97h defined by a lower end portion peripheral wall 97k at a lower surface.

An upper portion of the front wall 97a functions as a contact section 97g in an inclined shape corresponding to the main section 82a of the load receiver 82. As indicated by a two-dot chain line in FIG. 10, the contact section 97g is a portion with which a rear surface (back surface) of the backrest portion 6B may contact when the backrest portion 6B (seat 6) is reclined. The contact section 97g is in an inclined shape so as to correspond to the back surface of the backrest portion 6B in a state in which the backrest portion 6B is reclined to the maximum.

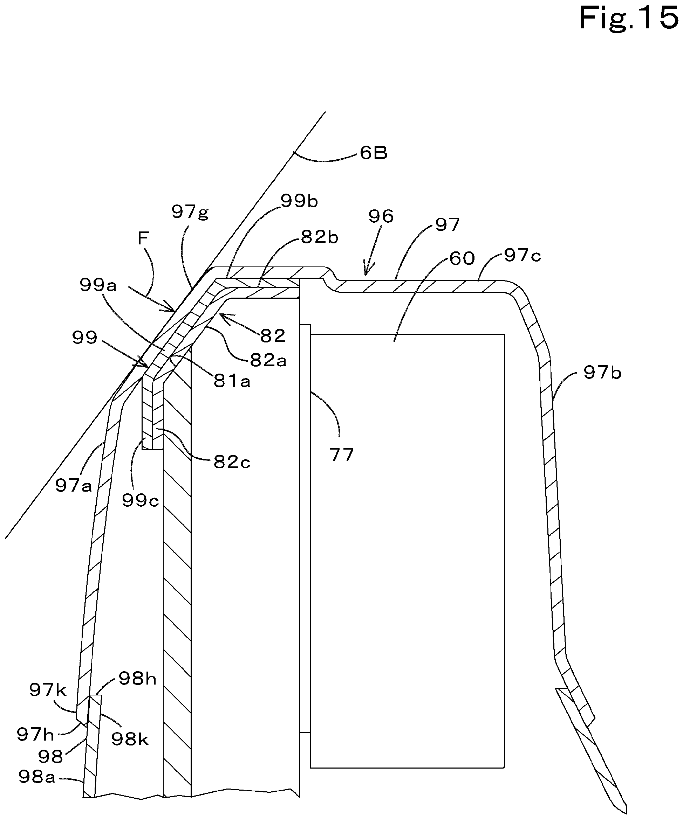

As illustrated in FIGS. 9 and 15, an intervening member 99 is provided between the contact section 97g and the load receiver 82. The intervening member 99 includes an elastic member. For example, the intervening member 99 is made of a plate material having elasticity (an elastic plate such as a rubber plate). The intervening member 99 is provided between and in close contact with the contact section 97g and the load receiver 82. Specifically, the intervening member 99 includes a first section 99a corresponding to the contact section 97g and the main section 82a of the load receiver 82 and being in close contact with the contact section 97g and the main section 82a, a second section 99b being in close contact with the upper wall 97c of the upper portion cover 97 and the upper portion wall 82b of the load receiver 82, and a third section 99c being in close contact with the lower portion wall 82c of the load receiver 82. The intervening member 99 is, for example, attached to the load receiver 82.

As illustrated in FIG. 15, when the backrest portion 6B is reclined and the backrest portion 6B contacts the cover member 96 (contact section 97g), a load F is applied from the backrest portion 6B to the cover member 96. The load F is transmitted to the load receiver 82 via the intervening member 99, and the load receiver 82 receives the load from the backrest portion 6B. That is, the load from the backrest portion 6B is received by the unit support 61. Accordingly, deformation, damage, or the like of the cover member 96 can be prevented.

For example, the contact section 97g may closely abut on the load receiver 82 to allow the load F applied to the cover member 96 to be transmitted to the unit support 61. However, since the cover member 96 is made of resin and the load receiver 82 is made of a metal plate material, it is difficult to cause the contact section 97g to closely abut on the load receiver 82. When a gap is formed between the contact section 97g and the load receiver 82, for example, the cover member 96 is deformed. By providing the intervening member 99 between and in close contact with the contact section 97g and the load receiver 82, the load F applied to the cover member 96 (contact section 97g) can be reliably transmitted to the unit support 61 (load receiver 82).

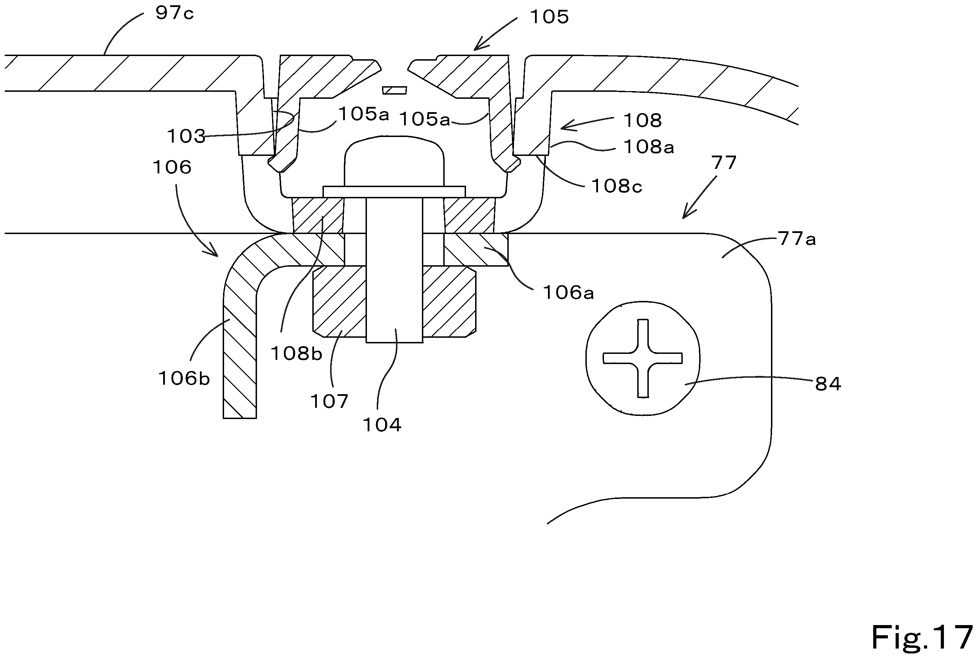

As illustrated in FIG. 14, a pair of bottomed attachment holes 103 for attaching the upper portion cover 97 to the unit support 61 are arranged in the upper wall 97c of the upper portion cover 97 in the machine-body width direction K2. As illustrated in FIG. 17, each of the attachment holes 103 is defined by a protruding portion 108 which opens upward. The protruding portion 108 is a wall portion of the upper wall 97c protruding downward and including a peripheral wall 108a and a bottom wall 108b. As illustrated in FIG. 12, attachment stay(s) 106 is fixed to an upper portion of a front surface of the first device bracket 77. The at least one attachment stay 106 includes attachment stays 106 provided on a left portion and a right portion of the first device bracket 77. Each of the attachment stays 106 includes an upper wall 106a and an extension wall 106b extending downward from the upper wall 106a. A nut member 107 is fixed to a lower surface of the upper wall 106a.

As illustrated in FIG. 17, the upper portion cover 97 is attached to the unit support 61 by a bolt member 104 that penetrates the bottom wall 108b of the protruding portion 108 (a bottom portion of the attachment hole 103) and the upper wall 106a of the attachment stay 106 and is screwed into the nut member 107 from above. By fixing the upper portion cover 97 to the unit support 61 with the bolt, a movement of the upper portion cover 97 relative to the unit support 61 can be reliably restricted.

As illustrated in FIG. 17, a cap 105 that hides the bolt member 104 is fitted into the attachment hole 103. The cap 105 includes a pair of engagement claws 195a, and is prevented from coming off by locking the pair of engagement claws 195a to engagement holes 108c in the peripheral wall 108a.

As illustrated in FIGS. 7, 9, 14, and 16, the lower portion cover 98 includes a first section 98a, a second section 98b, a third section 98c, and a fourth section 98d.

The first section 98a includes a front wall 98a1 that covers the front of a lower portion of the vertical member 81, a first side wall 98a2 that covers the left of the lower portion of the vertical member 81, a second side wall 98a3 that covers the right of the lower portion of the vertical member 81, and a rear wall 98a4 that couples upper portions of the first side wall 98a2 and the second side wall 98a3 to each other. The first section 98a is in a shape opening upward. That is, the first section 98a has an opening 98h defined by an upper end portion peripheral wall 98k at an upper surface.

As illustrated in FIGS. 9 and 15, a lower end portion of the upper portion cover 97 is fitted to an upper end portion of the first section 98a. Specifically, a fitting structure is provided in which the lower end portion peripheral wall 97k and the upper end portion peripheral wall 98k overlap each other in the horizontal direction and fitted to each other such that the lower end portion peripheral wall 97k of the upper portion cover 97 is located outward of the upper end portion peripheral wall 98k of the first section 98a. With this configuration, even when the upper portion cover 97 and the lower portion cover 98 are displaced in the up-down direction due to manufacturing tolerance, attachment, or the like of components, a significant change in visual impression can be prevented or reduced.

As illustrated in FIGS. 14 and 16, the second section 98b extends leftward from a lower portion of the first section 98a. An opening 98e for inspection is in the second section 98b. The second section 98b includes a lid member 98g that covers the opening 98e.

As illustrated in FIGS. 7 and 16, the third section 98c extends rightward from the lower portion of the first section 98a. The third section 98c covers the front and the upper side of the IPU 59 and the like.

The second section 98b and the third section 98c are attached to the coupling portion 29 (see FIG. 5) of the cabin 5.

As illustrated in FIGS. 14 and 16, the fourth section 98d extends forward from the first section 98a, the second section 98b, and the third section 98c. The fourth section 98d A includes a recessed compartment having an open top. As illustrated in FIG. 9, the fourth section 98d is attached to a stay 109 fixed to the vertical plate 38.

A working machine 1 of the present embodiment includes a machine body 2; a seat 6 on the machine body 2; and a communication unit 58 including an information processing device (IPU 59) and a communication device (DCU 60) to receive data from and transmit data to the information processing device 59, the communication device 60 containing a communication antenna 92 and configured to transmit data. The communication unit 58 is located at a position rearward of the seat 6 and lower than an upper end of the seat 6 such that the communication unit 58 overlaps the seat 6 in rear view.

With this configuration, since the communication unit 58 is located at a position rearward of the seat 6 and lower than the upper end of the seat 6 such that the communication unit 58 overlaps the seat 6 in rear view, the communication unit 58 can be provided in a useful layout such that the communication unit 58 does not hinder the user's front view, rear view, or side view.

The working machine 1 further includes a unit support 61 to which the communication unit 58 is attached; and a cover member 96 to cover the communication unit 58 and the unit support 61. The seat 6 includes a seat portion 6A for a user to sit on and a backrest portion 6B provided at a rear portion of the seat portion 6A such that the backrest portion 6B is reclineable. The unit support 61 includes a load receiver 82 to receive a load from the backrest portion 6B when the backrest portion 6B is reclined and the backrest portion 6B contacts the cover member 96.

With this configuration, when the backrest portion 6B is reclined and the backrest portion 6B contacts the cover member 96, the load from the backrest portion 6B can be received by the unit support 61, making it possible to eliminate or reduce the likelihood that the cover member 96 will be deformed.

The working machine 1 further includes an intervening member 99 including an elastic member and provided between and in close contact with the cover member 96 and the load receiver 82.

With this configuration, when the backrest portion 6B contacts the cover member 96, the load from the backrest portion 6B can be reliably transmitted to the load receiver 82 via the intervening member 99.

The working machine 1 further includes a seat protector (cabin 5) on the machine body 2; a prime mover E1 provided at a rear portion of the machine body 2; a hood 17 to house the prime mover E1; and a support frame 30 provided on the machine body 2 to support the hood 17. The seat protector 5 includes an attachment frame 35 attached to the support frame 30. The unit support 61 includes an attachment member 79 attached to the attachment frame 35.

With this configuration, the unit support 61 can be attached using the attachment frame 35 attached to the support frame 30, and an attachment structure of the communication unit 58 can be simplified.

The unit support 61 includes a pillar member 80 vertically provided on the attachment member 79 at a position that is rearward of the seat 6, a vertical member 81 located at the same side of the pillar member 80 as the seat 6 and fixed to the pillar member 80 such that the vertical member 81 protrudes upward, and a first device bracket 77 fixed at the opposite side of the vertical member 81 from the seat 6. The communication device 60 is located above the pillar member 80 and rearward of the first device bracket 77 and is attached to the first device bracket 77.

With this configuration, the attachment structure of the communication unit 58 can be made compact.

The load receiver 82 is provided at an upper end portion of the vertical member 81.

With this configuration, it is possible to increase load resistance against the load applied from the backrest portion 6B.

The unit support 61 includes a second device bracket 78 to which the information processing device 59 is attached. The second device bracket 78 is provided on the attachment member 79 such that the second device bracket 78 is located sideward of the pillar member 80 in a machine-body width direction K2.

With this configuration, the attachment structure of the communication unit 58 can be made compact.

While embodiments of the present invention have been described above, it is to be understood that the embodiments disclosed herein are considered as examples in all aspects and are not considered as limitations. The scope of the present invention is to be determined not by the foregoing description but by the claims, and is intended to include all variations and modifications within the scope of the claims and their equivalents.

### Reference Signs List

2 machine body
5 seat protector (cabin)
6 seat
6A seat portion
6B backrest portion
17 hood
30 support frame
35 attachment frame
58 communication unit
59 information processing device (IPU)
60 communication device (DCU)
60A device front surface
61 unit support
77 first device bracket
78 second device bracket
79 attachment member
80 pillar member
81 vertical member
82 load receiver
92 communication antenna
96 cover member
99 intervening member
E1 prime mover
K2 machine-body width direction

## Claims

1. A working machine comprising:
a machine body;
a seat on the machine body; and
a communication unit including an information processing device and a communication device to receive data from and transmit data to the information processing device, the communication device containing a communication antenna and configured to transmit data,
wherein
the communication unit is located at a position rearward of the seat and lower than an upper end of the seat such that the communication unit overlaps the seat in rear view.

2. The working machine according to claim 1, further comprising:
a unit support to which the communication unit is attached; and
a cover member to cover the communication unit and the unit support, wherein
the seat includes a seat portion for a user to sit on and a backrest portion provided at a rear portion of the seat portion such that the backrest portion is reclineable, and
the unit support includes a load receiver to receive a load from the backrest portion when the backrest portion is reclined and the backrest portion contacts the cover member.

3. The working machine according to claim 2, further comprising an intervening member including an elastic member and provided between and in close contact with the cover member and the load receiver.

4. The working machine according to claim 2 or 3, further comprising:
a seat protector on the machine body;
a prime mover provided at a rear portion of the machine body;
a hood to house the prime mover; and
a support frame provided on the machine body to support the hood, wherein
the seat protector includes an attachment frame attached to the support frame, and
the unit support includes an attachment member attached to the attachment frame.

5. The working machine according to claim 4, wherein
the unit support includes
a pillar member vertically provided on the attachment member at a position that is rearward of the seat,
a vertical member located at the same side of the pillar member as the seat and fixed to the pillar member such that the vertical member protrudes upward, and
a first device bracket fixed at the opposite side of the vertical member from the seat, and
the communication device is located above the pillar member and rearward of the first device bracket and is attached to the first device bracket.

6. The working machine according to claim 5, wherein the load receiver is provided at an upper end portion of the vertical member.

7. The working machine according to claim 5 or 6, wherein
the unit support includes a second device bracket to which the information processing device is attached, and
the second device bracket is provided on the attachment member such that the second device bracket is located sideward of the pillar member in a machine-body width direction.
